# EUROPEAN PATENT SPECIFICATION

(11) **EP 0 675 548 B1**
(45) Date of publication and mention of the grant of the patent: **07.08.2002**
(21) Application number: 95104614.3
(22) Date of filing: 29.03.1995
(51) Int. Cl.: H01L 29/92

(54) **Method of manufacturing semiconductor devices having a built-in capacitor**
Verfahren zur Herstellung von Halbleitervorrichtungen mit eingebautem Kondensator
Procédé pour fabriquer des dispositifs semi-conducteurs avec condensateur intégré

(30) Priority: 30.03.1994 JP 6088394; 25.04.1994 JP 8668694
(43) Date of publication of application: 04.10.1995
(60) Divisional application: 99103398.6
(73) Proprietor: MATSUSHITA ELECTRIC INDUSTRIAL CO., LTD., Kadoma-shi, Osaka (JP)
(72) Inventor: Matsumoto, Shoji, Kyoto-shi, Kyoto 612 (JP); Nagano, Yoshihisa, Suita-shi, Osaka 565 (JP); Shimada, Yasuhiro, Mishima-gun, Osaka 618 (JP); Izutsu, Yasufumi, Kyoto-fu 617 (JP)
(74) Representative: Kügele, Bernhard

(56) References cited:
- US-A- 5 094 712
- US-A- 5 254 217
- US-A- 5 258 332
- PATENT ABSTRACTS OF JAPAN, unexamined applications, E field, vol. 18, no. 419, August 5, 1994 THE PATENT OFFICE JAPANESE GOVERNMENT page 131 E 1589; & JP-A-06 132 255

## Description

### FIELD OF THE INVENTION

This invention relates to a method for manufacturing a semiconductor integrated circuit chip having a built-in capacitor in which high dielectric constant material or ferroelectric material is used as a capacitance insulation layer.

### BACKGROUND OF THE INVENTION

Recently, remarkable developments have occurred in the field of microcomputers having built-in capacitors of high dielectric constant materials. Such microcomputers contribute to reducing unnecessary radiation that causes electro-magnetic interference. Equally remarkable are developments in the field of ferroelectric non-volatile RAM which facilitates low-voltage operation and high read/write speed. The high dielectric constant materials or ferroelectric materials are made mainly of sintered metal oxide, and contain a substantial amount of very reactive oxygen. In forming a capacitor with such dielectric film, material for its electrodes must be least reactive; thus, precious metals such as platinum (Pt), palladium (Pd), etc. must be used.

In the prior art, platinum and palladium etching has been conducted by means of isotropic etching, such as wet etching with aqua regia or by ion milling with Ar gas. Because of the nature of isotropic etching, using wet etching with aqua regia and ion milling causes deteriorated processing accuracy. Furthermore, an additional problem with ion milling occurs because the etching speed on platinum, which is to form the electrode, and on silicon oxide, etc., which is underneath the platinum, are almost the same, the silicon oxide is also etched during ion milling.

In order to increase processing accuracy, research and development has been quite active in the precision processing technology with respect to the platinum layer and metal oxide dielectric thin film by means of a dry etching process, where Cl₂ and HBr are used as the etching gas (see, Extended Abstracts, Autumn Meeting 1991, The Japan Society of Applied Physics, 9P-ZF-17, p. 516; Extended Abstracts, Spring Meeting 1993, The Japan Society of Applied Physics, 30a-ZE-3, pp. 577).

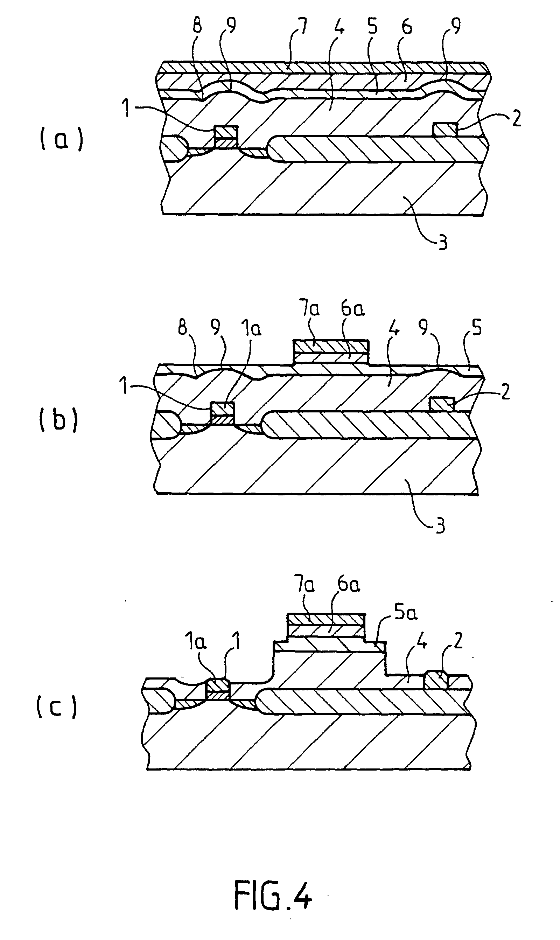

A conventional method for manufacturing semiconductor devices is described with reference to FIGs. 4(a)-(c). As shown in FIG. 4(a), a silicon oxide layer 4 is formed as an insulation layer on top of a circuit element 1 and a wiring 2 shaped on a silicon substrate 3. Over the silicon oxide layer 4 is a first platinum layer 5, a film of high dielectric constant material or ferroelectric material (hereinafter referred to as dielectric film) 6 and a second platinum layer 7.

The silicon oxide layer 4 reflects unevenness due to the circuit element 1 or wiring 2 already shaped on the silicon substrate 3 to have a hollow 8 or protrusion 9 on its surface, as shown in FIG.4(a). Because dielectric film 6 is spin-coated on the uneven surface of silicon oxide layer 4, thickness of the dielectric film 6 is large at the hollow 8, and small at the protrusion 9.

Next, as shown in FIG. 4(b), top electrode 7a and capacitance insulation film 6a are formed by dry-etching the second platinum layer 7 and dielectric film 6 with Cl₂, HBr as the etching gas. The facility used for the etching is a magnetron reactive ion etching (RIE) mode dry etcher. Through the same etching procedure the first platinum layer 5 is etched to form a bottom electrode 5a; and a capacitor is thus formed. A layer to protect the capacitor, electrode wiring and protection layer for the electrode wiring are formed through process steps not shown in the figure; and a semiconductor device is completed.

One example of such a type of dry etching method using a mixed gas of Cl₂, O₂ and HCl is disclosed in JP-A-061 32 255 (Patent Abstracts of Japan, vol. 18, No 419 (E-1589), August 5, 1994.

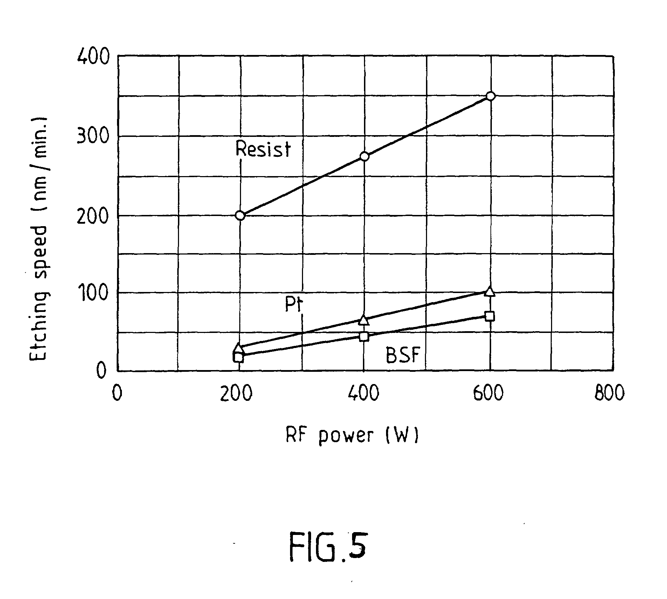

An example of the etching characteristics on platinum, high dielectric constant material (BaSrTiO₃, hereinafter referred to as BST) and resist is explained below when Cl₂ is used as the etching gas. FIG. 5 shows dependence of the etching speed of platinum, BST and resist to RF power. Where, the horizontal axis denotes RF power, the vertical axis denotes etching speeds of platinum, BST and resist.

The facility used for the etching is magnetron RIE mode dry etcher. The etcher conditions are: Cl₂ gas flow 20 sccm, gas pressure 1 Pa, RF power within a range between 200W and 600W, wafer temperature during etching below 20°C as its back surface is cooled with He.

FIG. 5 exhibits that platinum etching speed is increased from 30 nm/min. to 100 nm/min., BST etching speed is increased from 20 nm/min. to 70 nm/min. and resist etching speed is increased from 200 nm/min. to 350 nm/min., when RF power is raised from 200W to 600W.

When, the platinum/resist etching speed ratio increases from about 0.15 to about 0.29 along with the increase of RF power from 200W to 600W. The BST/resist etching speed ratio also increases from about 0.10 to about 0.20. Under any condition, the etching speed of resist is much faster than that of platinum and BST.

The time required to etch the platinum layer (200nm thick) and BST (200nm thick) with RF power at 600W is 4 min. 52 sec. The etching quantity of the resist during this time span is calculated from the resist etching speed to be 1703nm, a very large value. This means that, if the resist layer is thinner than 1700nm, the resist is entirely etched while etching is conducted on the platinum and BST. If this is to be prevented, a thick resist layer of more than about 3 µm thick has to be used.

As described above, however, when Cl₂ etching gas is used, the etching speed of resist is very high relative to that of platinum and BST. Consequently, while platinum and BST are being etched for a certain required thickness, the resist layer is also etched significantly. In order to prevent this from occurring a thick-layer resist needs to be used. But the thick-layer resist affects the definition level of the mask pattern at photolithography, rendering the formation of a fine pattern very difficult.

The etching speed of the silicon oxide layer is about 2.5 times faster than that of the platinum layer. So, as shown in FIG. 4(c), during formation of bottom electrode 5a, its underlayer, the silicon oxide layer 4 is significantly etched.

The problem with etching the silicon oxide layer 4 is illustrated in FIGs. 4(b) and 4(c). Before the thick part of first platinum layer 5 (located on the hollow 8 of silicon oxide layer 4) is completely etched off, the etching gas, which already etched the thin part of first platinum layer 5 (located on the extrusion 9 of silicon oxide layer 4), quickly attacks the underlying silicon oxide layer 4 to etch it off, and when gate electrode 1a of circuit element 1 and wiring 2 are exposed, they are also etched, rendering the transistor and other circuit element 1 inoperable.

In the case of ion milling where Ar gas is used as the etching gas, because the ratio of the etching speed of the second platinum layer 7 and dielectric film 6 to the etching speed of the silicon oxide layer 4 is low, when forming a capacitor in two separate etching process steps (e.g., etching on the second platinum layer 7 and dielectric film 6, and then on the first platinum layer 5), it is extremely difficult to stop the etching procedure so that the first platinum layer is not etched.

In the case of dry etching on platinum and ferroelectric material, because of its slow etching speed, the throughput of the production facility is poor.

### SUMMARY OF THE INVENTION

The objective of this invention is to offer a new method for manufacturing semiconductor devices having a built-in capacitor which is formed by slowing the etching speed on the resist, making the ratio of etching speed of platinum and dielectric material to resist large, and by selectively dry-etching the platinum and dielectric material at a fast etching speed.

Further, another objective of this invention is to offer a new method of manufacturing semiconductor devices, wherein, even if sufficient time is provided for overetching during the process to form the bottom electrode of the capacitor, the silicon oxide layer underneath the electrode is only minimally etched, hence circuit elements and wirings, etc. are protected from damage; thereby highly reliable semiconductor devices can be manufactured.

This invention relates to a method of manufacturing a semiconductor device comprising the steps of : forming an insulating layer, a first metal layer, a dielectric film, and a second metal layer on a substrate having circuit elements formed thereon wherein said insulating layer is a silicon insulating layer and said first metal layer is a platinum layer; dry etching said second metal layer and said dielectric film to form a top electrode and a capacitance insulation film ; and after dry etching said second metal layer and said dielectric film, dry etching said platinum layer to form a bottom electrode by using mixed gas containing exclusively hydrogen halide and oxygen, or hydrogen halide and a compound gas containing oxygen.

In a first embodiment of the present invention, the percentage of oxygen in the etching gas of hydrogen halide and oxygen is about 10% to about 35%.

In another embodiment of the present invention, the hydrogen halide is HBr.

In still another embodiment of the present invention, said second metal layer is made of platinum or palladium.

The invention itself, together with further objects and attendant advantages, will be understood by reference to the following detailed description taken in conjunction with the accompanying drawings.

### BRIEF DESCRIPTION OF THE DRAWINGS

Figs. 1(a)-(d) are cross-sectional views showing the first half of the process steps of this invention.

Figs. 2(a)-(c) are cross-sectional views showing the second half of the process steps.

Fig. 3 is a characteristic chart showing the etching speed of the etching gas used.

Figs. 4(a)-(c) show cross-sectional views of a conventional method for manufacturing semiconductor devices.

Fig. 5 is a characteristics chart showing the relationship between the etching speeds of platinum, BST and resist and the HF power, when Cl₂ gas is used as the etching gas in a conventional manufacturing method.

### DESCRIPTION OF PREFERRED EMBODIMENTS

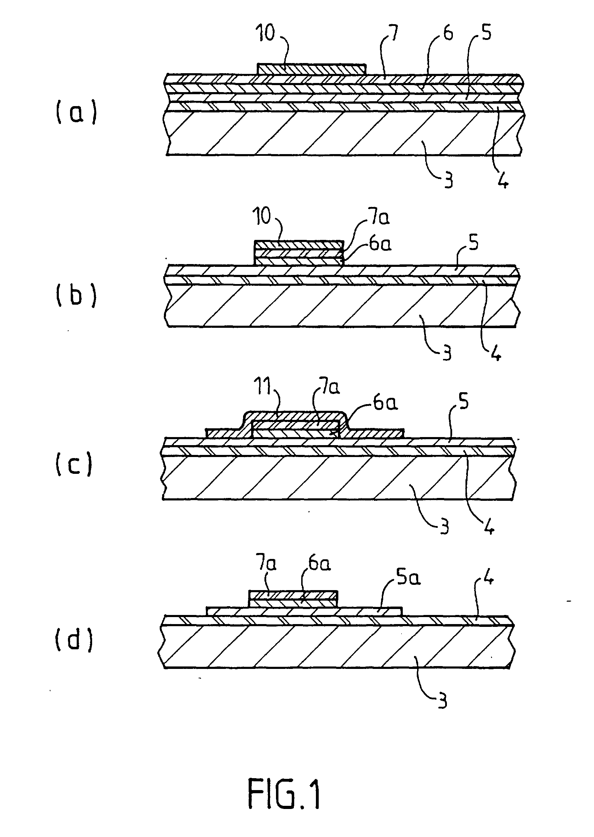

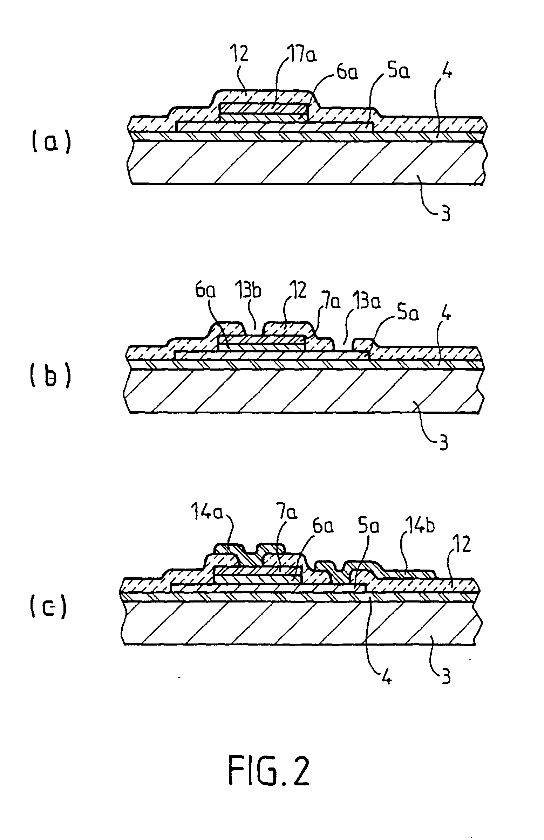

One Embodiment of this invention is described below referring to Figs. 1(a)-(d) and Figs. 2(a)-(c), where the same constituent parts as the conventional parts shown in Fig. 4 are identified with the same numerals and their explanations are omitted, explaining only those elements that are different from the conventional method.

In Figs. 1(a)-(d) and Figs. 2(a)-(c), the circuit element 1 and wiring 2 as shown in FIG. 8 are omitted, and only the sector of a capacitor is described.

First, as shown in FIG. 1(a), an insulation layer 4 of silicon oxide is formed on the substrate 3 made of silicon, etc. On top of the insulation layer 4 is a first platinum layer 5 of about 200nm thickness. On top of the first platinum layer 5 is a dielectric film 6 having a high dielectric constant material or ferroelectric material of about 200nm thickness. Further on top of the dielectric film 6 is a second platinum layer 7 of about 200nm thickness. The dielectric film 6 is formed by means of the spin coating method. Then, top electrode 7a and a capacitance insulation film 6a are formed by dry etching the second platinum layer 7 and dielectric film 6, through a resist layer 10 applied on the second platinum layer 7. In this way, a device as shown in FIG. 1(b) is formed. Next, as shown in FIG. 1(c), the top electrode 7a, capacitance insulation film 6a and a part of the first platinum layer 5 are covered with a second resist layer 11 to etch the first platinum layer 5 with a mixed gas of HBr and O₂. Bottom electrode 5a is thus formed, as shown in FIG. 1(d).

As shown in FIG. 2(a), an interlayer insulation layer 12 is coated over the entire surface, contact holes 13a and 13b are provided above the bottom electrode 5a and top electrode 7a, respectively (Fig. 2(b)), and electrode wirings 14a and 14b, which connect to the top electrode 7a and bottom electrode 5a, respectively, via the contact holes 13b, 13a, are formed to complete a capacitor (FIG. 2(c)).

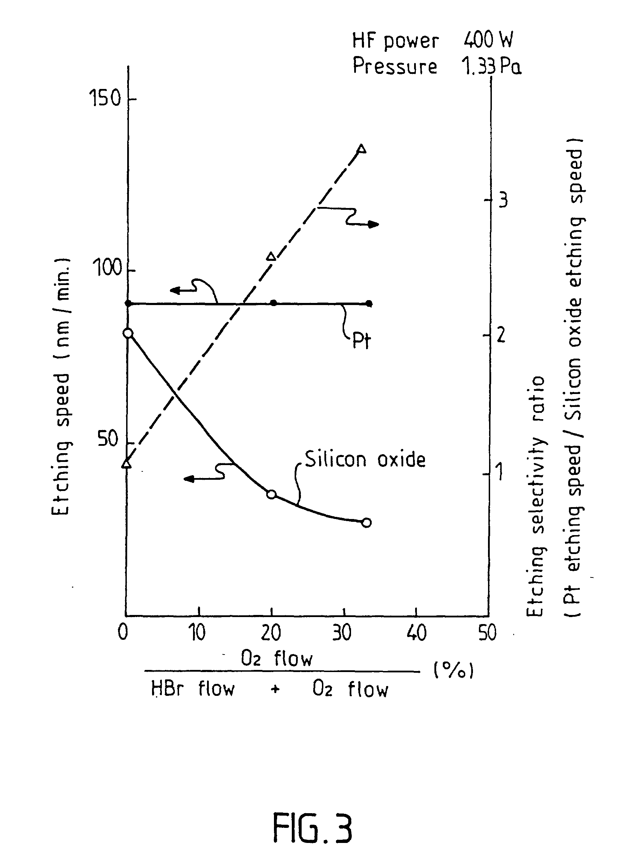

The use of a mixed gas of HBr and O₂ as the etching gas in dry etching the silicon oxide layer 4, the first platinum layer 5 and the second platinum layer 7, is explained below with reference to Fig. 3.

FIG. 3 shows the etching speeds of platinum and silicon oxide when HBr and O₂ mixed gas is used. The left vertical axis denotes the etching speeds of platinum and silicon oxide, the right vertical axis denotes the etching selectivity ratio (platinum etching speed/silicon oxide etching speed), and the horizontal axis indicates percentage of O₂ flow to the HBr and O₂ total etching gas flow. The etching facility used is a magnetron RIE mode dry etcher, with HF power 400W and pressure 1.33Pₐ during etching.

As indicated in FIG. 3, the etching speed on silicon oxide when HBr alone is used as the etching gas is about 80 nm/min., which is about half the speed when chloroform is used as the etching gas, or almost the same level as that on platinum (90 nm/min.). Namely, the platinum/silicon oxide etching selectivity ratio is approximately 1.

When O₂ is mixed with HBr such that O₂ comprises about 30% of the total flow of etching gas, the speed of etching on silicon oxide decreases to about 1/3 as compared with the case of HBr alone; while the etching speed on platinum stays almost unchanged. This means that the platinum/silicon oxide etching selectivity ratio is improved to more than 3. In practical cases the process can be maintained stable when the ratio is 1.5 and up, therefore, the quantity of O₂ to the total etching gas flow may be chosen from the range of about 10%-35%.

In the case when platinum is dry etched using HBr and O₂ mixed gas, the silicon oxide reacts with Br and O₂ to compose a non-volatile compound which piles up on the silicon oxide layer 4 to protect the silicon oxide layer 4, lowering the etching speed. This makes it possible to selectively etch the first platinum layer 5. Namely, in completely etching off the first platinum layer 5, the silicon oxide layer 4 is never substantially etched as was the case in the conventional manufacturing method. Thus, possible damage to the circuit elements and wirings which are located underneath the silicon oxide layer 4 is avoided.

Although a platinum layer is used as the top electrode 7a and bottom electrode 5a in this embodiment, the same effect is also obtained by the use of a less reactive metal, such as palladium.

Besides O₂ gas used in this embodiment as the gas to be mixed to HBr, a compound gas containing oxygen may also be used.

As described above, in this embodiment, where a mixed gas of oxygen and hydrogen halide such as HBr is used as the etching gas for forming the bottom electrode 5a made of platinum, etc., only the first metal layer 5 made of platinum, etc. is selectively etched off, and etching of the silicon oxide layer 4 is reduced therefore the circuit elements and wiring, etc. underneath the silicon oxide layer are not damaged.

Through the process steps as explained by the foregoing description, a capacitor consisting of the second platinum layer 7 as top electrode, dielectric film 6 and the first platinum layer 5 as bottom electrode may be formed with high precision and without difficulty of manufacturing.

Of course, it should be understood that modifications can be made to the preferred embodiment described above. It is therefore intended that the foregoing detailed description be regarded as illustrative rather than limiting and that the following claims define the scope of this invention.

## Claims

1. A method of manufacturing a semiconductor device comprising the steps of:
forming an insulating layer (4), a first metal layer (5), a dielectric film (6), and a second metal layer (7) on a substrate (3) having circuit elements formed thereon, wherein said insulating layer is a silicon oxide insulating layer (4) and said first metal layer is a platinum layer (5);
dry etching said second metal layer (7) and said dielectric film (6) to form a top electrode (7a) and a capacitance insulation film (6a); and
after dry etching said second metal layer (7) and said dielectric film (6), dry etching said platinum layer (5) to form a bottom electrode (5a) by using mixed gas containing exclusively hydrogen halide and oxygen, or hydrogen halide and a compound gas containing oxygen.

2. A method of manufacturing a semiconductor device according claim 1, wherein the percentage of oxygen in the etching gas of hydrogen halide and oxygen is about 10% to about 35%.

3. A method of manufacturing a semiconductor device according to claim 1 or claim 2, wherein the hydrogen halide is HBr.

4. A method of manufacturing a semiconductor device according to any of claims 1 to 3, wherein said second metal layer (5, 7) is made of platinum or palladium.

## Patentansprüche

1. Verfahren zur Herstellung einer Halbleiteranordnung mit den Schritten
Ausbildung einer Isolierschicht (4), einer ersten Metallschicht (5), einer dielektrischen Dünnschicht (6) und einer zweiten Metallschicht (7) auf einem Substrat (3) mit darauf ausgebildeten Schaltkreiselementen, wobei die Isolierschicht eine Siliciumoxid-Isolierschicht (4) ist und die erste Metallschicht eine Platinschicht (5) ist;
Trockenätzen der zweiten Metallschicht (7) und der dielektrischen Dünnschicht (6) zur Ausbildung einer oberen Elektrode (7a) und einer kapazitiven Isolierschicht (6a)
und nach dem Trockenätzen der zweiten Metallschicht (7) und der dielektrischen Dünnschicht (6) Trockenätzen der Platinschicht (5) zur Ausbildung einer unteren Elektrode (5a) durch Verwendung eines Mischgases, das nur Halogenwasserstoff und Sauerstoff oder Halogenwasserstoff und ein Sauerstoff-haltiges zusammengesetztes Gas enthält.

2. Verfahren zur Herstellung einer Halbleiteranordnung nach Anspruch 1, **dadurch gekennzeichnet, dass** der Anteil von Sauerstoff an dem aus Halogenwasserstoff und Sauerstoff bestehenden Ätzgas etwa 10 bis etwa 35 % beträgt.

3. Verfahren zur Herstellung einer Halbleiteranordnung nach Anspruch 1 oder 2, **dadurch gekennzeichnet, dass** der Halogenwasserstoff HBr ist.

4. Verfahren zur Herstellung einer Halbleiteranordnung nach einem der Ansprüche 1 bis 3, **dadurch gekennzeichnet, dass** die zweite Metallschicht (5, 7) aus Platin oder Palladium besteht.

## Revendications

1. Procédé de fabrication d'un dispositif à semiconducteur comprenant les étapes consistant à :
former une couche isolante (4), une première couche de métal (5), un film diélectrique (6) et une seconde couche de métal (7) sur un substrat (3) comportant des éléments de circuit formés sur celui-ci, dans lequel ladite couche isolante est une couche isolante d'oxyde de silicium (4) et ladite première couche de métal est une couche de platine (5),
graver à sec ladite seconde couche de métal (7) et ledit film diélectrique (6) afin de former une électrode supérieure (7a) et un film d'isolement de capacité (6a), et
après gravure à sec de ladite seconde couche de métal (7) et dudit film diélectrique (7), graver à sec ladite couche de platine (5) afin de former une électrode inférieure (5a) en utilisant un gaz mixte contenant exclusivement un halogénure d'hydrogène et de l'oxygène, ou un halogénure d'hydrogène et un gaz composé contenant de l'oxygène.

2. Procédé de fabrication d'un dispositif à semiconducteur selon la revendication 1, dans lequel le pourcentage d'oxygène dans le gaz de gravure d'halogénure d'hydrogène et d'oxygène est d'environ 10 % à environ 35 %.

3. Procédé de fabrication d'un dispositif à semiconducteur selon la revendication 1 ou la revendication 2, dans lequel l'halogénure d'hydrogène est HBr.

4. Procédé de fabrication d'un dispositif à semiconducteur selon l'une quelconque des revendications 1 à 3, dans lequel ladite seconde couche de métal (5, 7) est faite de platine ou de palladium.
